# EUROPEAN PATENT APPLICATION

(11) **EP 4 738 360 A1**
(43) Date of publication of application: **06.05.2026**
(21) Application number: 25211380.8
(22) Date of filing: 27.10.2025
(51) Int. Cl.: G11C 7/22, G11C 8/08, G11C 8/16, G11C 8/18, G11C 11/412, G11C 11/418

(54) **MULTI-PORT STATIC RANDOM ACCESS MEMORY CELL HAVING WRITE WORD LINE OR READ WORD LINE ASSERTED MORE THAN ONCE DURING ONE CLOCK CYCLE AND ASSOCIATED STATIC RANDOM ACCESS MEMORY WITH MULTI-PORT STATIC RANDOM ACCESS MEMORY CELLS**

(30) Priority: 01.11.2024 US 202463714866 P; 22.10.2025 US 202519366482
(71) Applicant: MEDIATEK INC., Hsinchu City 30078 (TW)
(72) Inventor: HONG, Chi-Hao, Hsinchu City 30078 (TW)
(74) Representative: Hoefer & Partner Patentanwälte mbB

(57) **Abstract**

A multi-port static random access memory, SRAM, cell (200) includes a storage circuit (206), a plurality of write port circuits (202_1, 202_2, 202_M'), and a plurality of read port circuits (204_1, 204_2, 204_N'). The storage circuit (206) is used to store one bit. The write port circuits (202_1, 202_2, 202_M') are coupled to a first node of the storage circuit (206). Each of the write port circuits (202_1, 202_2, 202_M') is coupled to a write word line, WWL, and a write bit line, WBL. The read port circuits (204_1, 204_2, 204_N') are coupled to a second node of the storage circuit (206). Each of the read port circuits (204_1, 204_2, 204_N') is coupled to a read word line, RWL, and a read bit line, RBL. The WWL or the RWL is asserted more than once during a clock cycle of a clock.

## Description

### Field of the Invention

The present invention relates to a static random access memory (SRAM) design, and more particularly, to a multi-port SRAM cell having a write word line (WWL) and/or a read word line (RWL) asserted more than once during one clock cycle and an associated SRAM with multi-port SRAM cells.

### Background of the Invention

In high speed computers and digital signal processors, multiport SRAMs are essential components, especially in modern multi-core system on a chip (SoC). For example, a conventional multi-port SRAM cell that allows simultaneous N read operations/M write operations is required to have N read ports and M write ports. When the numbers of read ports and write ports are increased to meet requirements of high speed applications, a conventional SRAM with multi-port SRAM cells requires a larger die area, which increases the area and the power consumption of the SOC. Thus, there is a need for an innovative multi-port SRAM cell design which provides simultaneous N read operations by using N' (N' < N) read ports and provides simultaneous M write operations by using M' (M' < M) write ports.

### Summary of the Invention

This in mind, the present invention aims at providing a multi-port SRAM cell having a WWL and/or an RWL asserted more than once during one clock cycle and an associated SRAM with multi-port SRAM cells.

This is achieved by the multi-port SRAM cell and the SRAM according to the independent claims. The dependent claims pertain to corresponding further developments and improvements.

As will be seen more clearly from the detailed description following below, the claimed multi-port SRAM cell includes a storage circuit, a plurality of write port circuits, and a plurality of read port circuits. The storage circuit is configured to store one bit. The write port circuits are coupled to a first node of the storage circuit. Each of the write port circuits is coupled to a write word line (WWL) and a write bit line (WBL). The read port circuits are coupled to a second node of the storage circuit. Each of the read port circuits is coupled to a read word line (RWL) and a read bit line (RBL). The WWL or the RWL is asserted more than once during a clock cycle of a clock.

In addition, the claimed SRAM includes a memory array and a peripheral circuit. The memory array includes a plurality of SRAM cells, each being implemented by the claimed multi-port SRAM cell.

### Brief Description of the Drawings

In the following, the invention is further illustrated by way of example, taking reference to the accompanying drawings. Thereof
FIG. 1 is a diagram illustrating an SRAM design according to an embodiment of the present invention,
FIG. 2 is a diagram illustrating a multi-port SRAM cell design according to an embodiment of the present invention,
FIG. 3 is a diagram illustrating waveforms of WWL signals and RWL signals used by a double-pumped 4R4W multiport-SRAM cell according to an embodiment of the present invention,
FIG. 4 is a diagram illustrating a DI circuit design according to an embodiment of the present invention, and
FIG. 5 is a diagram illustrating a DO circuit design according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

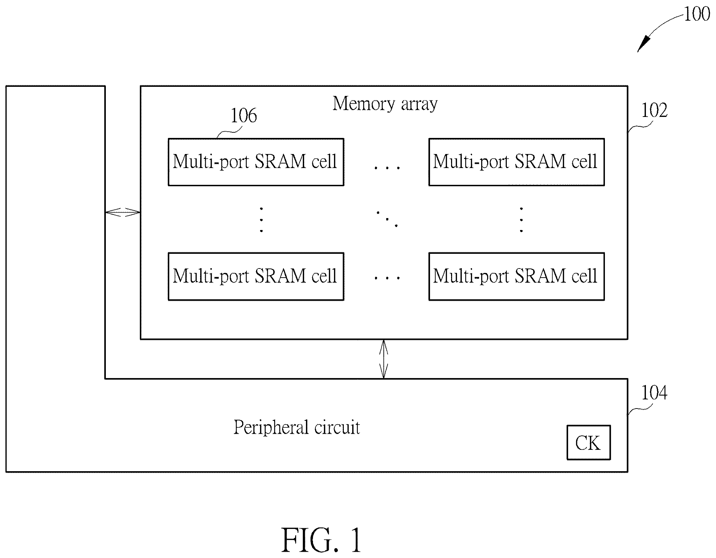

FIG. 1 is a diagram illustrating an SRAM design according to an embodiment of the present invention. The SRAM 100 includes a memory array 102 and a peripheral circuit 104. The memory array 102 includes a plurality of multi-port SRAM cells (also called bit-cells) 106 arranged in a two-dimensional (2D) array with a plurality of rows and a plurality of columns. Each of the multi-port SRAM cells 106 has the proposed multi-port SRAM cell design. The peripheral circuit 104 acts as an input/output (I/O) circuit used to control access (read/write) of the multi-port SRAM cells 106 in the memory array 102. For example, the peripheral circuit 104 may include a row decoder, a timing controller, a column decoder, a sense amplifier, etc.

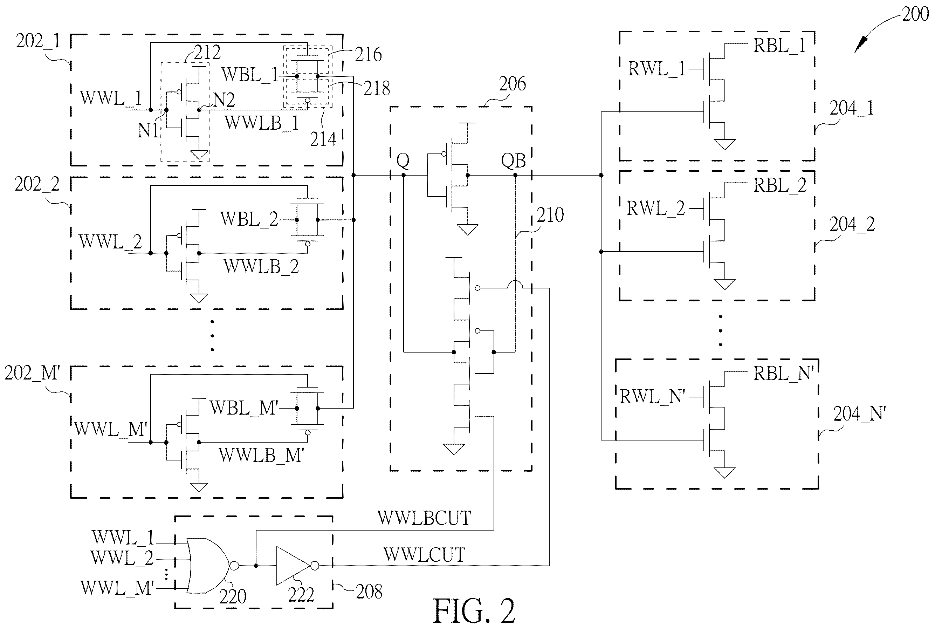

FIG. 2 is a diagram illustrating a multi-port SRAM cell design according to an embodiment of the present invention. Each of the multi-port SRAM cells 106 shown in FIG. 1 may be implemented using the multi-port SRAM cell 200 shown in FIG. 2. The multi-port SRAM cell 200 includes a plurality of write port circuits 202_1-202_M', a plurality of read port circuits 204_1-204_N', a storage circuit 206, and a logic circuit 208. The storage circuit 206 is configured to store one bit. For example, the storage circuit 206 may be implemented using a feedback latch with a feedback loop 210. The write port circuits 202_1-202_M' are coupled to a first node Q of the storage circuit 206. The read port circuits 204_1-204_N' are coupled to a second node QB of the storage circuit 206. Each of the write port circuits 202_1-202_M' is coupled to a write word line (WWL) and a write bit line (WBL), where WWL is a global word line, and WBL is a global bit line. For example, the write port circuit 202_1 is coupled to WWL_1 and WBL_1, the write port circuit 202_2 is coupled to WWL_2 and WBL_2, and the write port circuit 202_M' is coupled to WWL_M' and WBL_M'. Each of the read port circuits 204_1-204_N' is coupled to a read word line (RWL) and a read bit line (RBL), where RWL is a global word line, and RBL is a global bit line. For example, the read port circuit 204_1 is coupled to RWL_1 and RBL_1, the read port circuit 204_2 is coupled to RWL_2 and RBL_2, and the read port circuit 202_N' is coupled to RWL_N' and RBL_N'.

In some embodiments of the present invention, WWL of each write port circuit is asserted more than once during a clock cycle of an SRAM clock CK. In some embodiments of the present invention, RWL of each read port circuit is asserted more than once during a clock cycle of the SRAM clock CK. For example, WWL is asserted twice during one clock cycle of the SRAM clock CK, thereby enabling a double-pumped write operation of the storage circuit 206 during one clock cycle of the SRAM clock CK; and/or RWL is asserted twice during one clock cycle of the SRAM clock CK, thereby enabling a double-pumped read operation of the storage circuit 206 during one clock cycle of the SRAM clock CK.

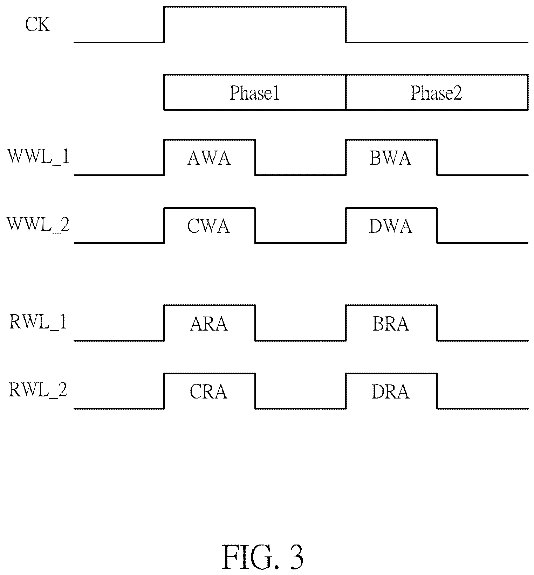

FIG. 3 is a diagram illustrating waveforms of WWL signals and RWL signals used by a double-pumped 4R4W multiport-SRAM cell according to an embodiment of the present invention. Suppose that the multi-port SRAM cell 200 shown in FIG. 2 is a double-pumped 4R4W multiport-SRAM cell having two (N'=2) read port circuits 204_1, 204_2 and two (M' = 2) write port circuits 202_1, 202_2. One clock cycle of the SRAM clock CK is divided into a first phase Phase1 and a second phase Phase2. With regard to simultaneous write operations of the same multi-port SRAM cell, a WWL signal on WWL_1 has a first pulse during the first phase Phase1 for enabling a write operation AWA of writing a bit of a first data input transmitted on WBL_1 into the storage circuit 206, and has a second pulse during the following second phase Phase2 for enabling another write operation BWA of writing a bit of a second data input transmitted on the same WBL_1 into the storage circuit 206; and a WWL signal on WWL_2 has a first pulse during the first phase Phase1 for enabling a write operation CWA of writing a bit of a third data input transmitted on WBL_2 into the storage circuit 206, and has a second pulse during the following second phase Phase2 for enabling another write operation DWA of writing a bit of a fourth data input transmitted on the same WBL_2 into the storage circuit 206.

With regard to simultaneous read operations of the same multi-port SRAM cell, an RWL signal on RWL_1 has a first pulse during the first phase Phase1 for enabling a read operation ARA of reading a bit of a first data output from the storage circuit 206 to RBL_1, and has a second pulse during the following second phase Phase2 for enabling another read operation BRA of reading a bit of a second data output from the storage circuit 206 to the same RBL_1; and an RWL signal on RWL_2 has a first pulse during the first phase Phase1 for enabling a read operation CRA of reading a bit of a third data output from the storage circuit 206 to RBL_2, and has a second pulse during the following second phase Phase2 for enabling another read operation DRA of reading a bit of a fourth data output from the storage circuit 206 to the same WBL_2.

A conventional multi-port SRAM cell that allows simultaneous N read operations/M write operations is required to have N read ports and M write ports. The proposed multi-port SRAM cell 200 has a WWL asserted more than once during one SRAM clock cycle and/or an RWL asserted more than once during one SRAM clock cycle. Hence, the proposed multi-port SRAM cell 200 can achieve simultaneous N read operations by only using N' (N' < N) read port circuits 204_1-204_N', and/or can achieve simultaneous M write operations by only using M' (M' < M) write port circuits 202_1-202_M'. For example, when proposed multi-port SRAM cell 200 is configured to act as a double-pumped N-read/M-write multi-port SRAM cell, N' is equal to N/2, and M' is equal to M/2. Compared to the conventional multi-port SRAM cell, the proposed multi-port SRAM cell 200 occupies a smaller die area and has lower power consumption.

Each of the write port circuits 202_1-202_M' may have the same circuit structure. Taking the write port circuit 202_1 for example, it includes an inverter circuit 212 and a transmission gate 214. The inverter circuit 212 has an input node N1 and an output node N2. The transmission gate 214 includes two MOS transistors 216, 218, each having a control terminal, a first connection terminal, and a second connection terminal. The input node N1 of the inverter circuit 212 is coupled to WWL_1 and the control terminal of the MOS transistor 216. The output node N2 of the inverter circuit 212 is coupled to the control terminal of the MOS transistor 218 through a write word line (which is a local word line) WWLB_1. The first connection terminal of the MOS transistor 216 and the first connection terminal of the MOS transistor 218 are coupled to WBL_1. The second connection terminal of the MOS transistor 216 and the second connection terminal of the MOS transistor 218 are coupled to the first node Q of the storage circuit 206. The MOS transistor 216 of the transmission gate 214 is controlled by a global write word line WWL_1. With the aid of the inverter circuit 212, the other MOS transistor 218 of the transmission gate 214 is controlled by a local write word line WWLB_1 rather than a global write word line. In this way, the global signal routing can be greatly reduced.

Since a person skilled in the art can readily understand details of other write port circuits 202_2-202_M' after reading above paragraph directed to the write port circuit 202_1, further description is omitted here for brevity. In addition, each of the read port circuits 204_1-204_N' may be implemented using any read circuit capable for setting a voltage level on RBL according to the bit stored in the storage circuit 206 when RWL is asserted.

In this embodiment, the storage circuit 206 is implemented by a feedback latch. The logic circuit 208 has a plurality of input nodes coupled to WWL_1-WWL_M', respectively. The logic circuit 208 is configured to generate at least one control signal which determines whether to cut off the feedback loop 210 of the storage circuit 206. In this embodiment, the logic circuit 208 includes an OR gate 220 and an inverter circuit (also called NOT gate) 222. An output signal of the OR gate 220 serves as one control signal WWLBCUT of the feedback loop 210. An output signal of the inverter circuit 222 serves as another control signal WWLCUT of the feedback loop 210. When any of WWL_1-WWL_M' is asserted, the feedback loop 210 is cut off to facilitate a write operation performed upon the storage circuit 206. When all of WWL_1-WWL_M' are deasserted, the feedback loop 210 is enabled to latch a bit written into the storage circuit 206.

As mentioned above, the peripheral circuit 104 acts as an I/O circuit used to control access (read/write) of the multi-port SRAM cells 106 in the memory array 102. For example, each of the multi-port SRAM cells 106 is implemented using the proposed multi-port SRAM cell 200 that may be a double-pumped N-read/M-write multi-port SRAM cell. Hence, the peripheral circuit 104 may include a data-in (DI) circuit used to set bits of different data inputs transmitted on a WBL coupled to a write port circuit, and may include a data-out (DO) circuit used to output bits of different data outputs transmitted on an RBL coupled to a read port circuit.

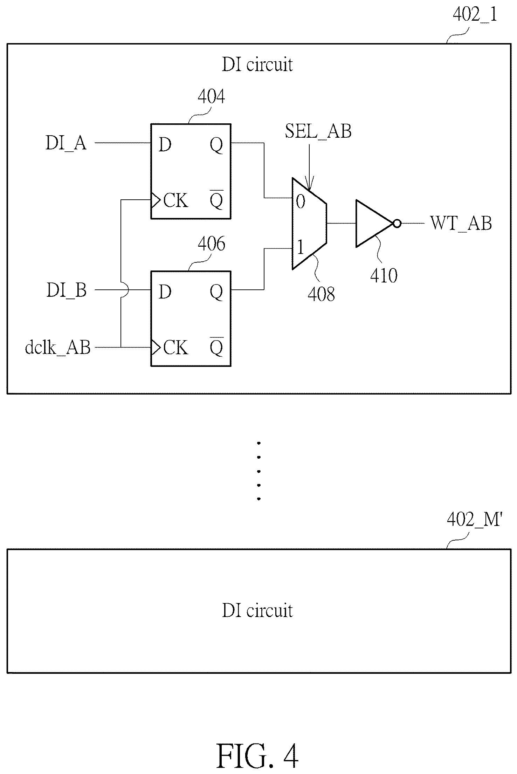

FIG. 4 is a diagram illustrating a DI circuit design according to an embodiment of the present invention. The peripheral circuit 104 includes a plurality of DI circuits 402_1-402_M' coupled to the write port circuits 202_1-202_M', respectively. Each of the DI circuits 402_1-402_M' may have the same circuit structure. Taking the DI circuit 402_1 for example, it includes digital circuits 404, 406, a multiplexer circuit 408, and a driver circuit 410. The digital circuit 404 is configured to store a first bit DI_A to be provided to the write port circuit 202_1. The digital circuit 406 is configured to store a second bit DI_B to be provided to the write port circuit 202_1. The multiplexer circuit 408 has a first input node (labeled by "0"), a second input node (labeled by "1"), and an output node, where the first input node is coupled to the digital circuit 404, and the second input node is coupled to the digital circuit 406. A control signal SEL_AB is set to control the multiplexer circuit 408 to couple the output node to one of the first input node and the second input node. In this embodiment, the output node is configured to output the first bit DI_A during a first phase Phase1 of a clock cycle of a clock dclk_AB and output the second bit DI_B during the second phase Phase2 of the clock cycle of the clock dclk_AB, where the clock dclk_AB is derived from the SRAM clock CK. The driver circuit 410 is configured to generate a driving signal WT_AB according to an output signal generated from the output node of the multiplexer circuit 408. Specifically, during a double-pumped write operation in one clock cycle, WBL_1 is driven according to the driving signal WT_AB.

Flip-flops and latches are two kinds of memory circuits used in electronics. The main difference between them is how they react to changes. A latch changes its output whenever its input changes. This means it's always ready to respond. On the other hand, a flip-flop only changes its output at specific moments. For example, the flip-flop may be allowed to change its output when its control signal goes from low to high. For another example, the flip-flop may be allowed to change its output when its control signal goes from high to low. To put it simply, latches are always alert to changes, while flip-flops only act at certain times. Hence, a latch has 0 cycle latency, and a DFF has 1 cycle latency.

In some embodiments of the present invention, the digital circuit 404 (which is responsible for providing DI_A during the first phase Phase1) may be implemented by a latch circuit, and the digital circuit 406 (which is responsible for providing DI_B during the second phase Phase2 following the first phase Phasel) may be implemented by a DFF circuit to reduce the setup time. However, this is for illustrative purposes only, and is not meant to be a limitation of the present invention. Alternatively, both of the digital circuits 404 and 406 may be implemented using latch circuits.

In some embodiments of the present invention, the digital circuits 404 and 406 are both triggered by a rising edge of the clock dclk_AB (which is derived from the SRAM clock CK). However, this is for illustrative purposes only, and is not meant to be a limitation of the present invention. Alternatively, the digital circuit 404 (which is responsible for providing DI_A during the first phase Phasel) is triggered by a rising edge of the clock delk_AB (which is derived from the SRAM clock CK), and the digital circuit 406 (which is responsible for providing DI_B during the second phase Phase2 following the first phase Phase1) is triggered by a falling edge of the clock dclk_AB (which is derived from the SRAM clock CK).

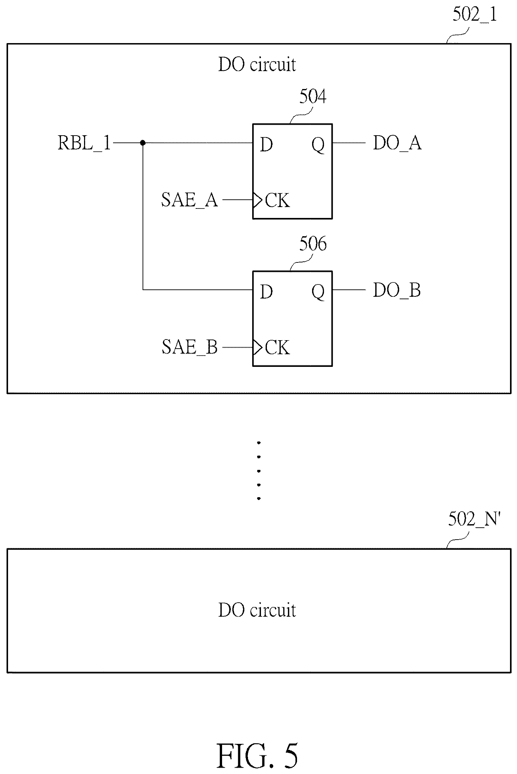

FIG. 5 is a diagram illustrating a DO circuit design according to an embodiment of the present invention. The peripheral circuit 104 includes a plurality of DO circuits 502_1-502_N' coupled to the read port circuits 204_1-204_N', respectively. Each of the DO circuits 502_1-502_N' may have the same circuit structure. Taking the DO circuit 502_1 for example, it includes digital circuits 504 and 506. Specifically, the digital circuits 504 and 506 act as output latches, and are triggered by latch clocks SAE_A and SAE_B, respectively. The digital circuit 504 is configured to store one bit DO_A output from the read port circuit 204_1 (particularly, RBL_1 driven by read port circuit 204_1) during a first phase Phase1 of a clock cycle of the SRAM clock CK. The digital circuit 506 is configured to store one bit output from the read port circuit 204_1 (particularly, RBL_1 driven by read port circuit 204_1) during a second phase Phase2 of the clock cycle of the SRAM clock CK.

In some embodiments of the present invention, both of the digital circuits 504 and 506 are implemented using latch circuits. In some embodiments of the present invention, the digital circuit 504 is a latch circuit, and the digital circuit 506 is a DFF circuit. In some embodiments of the present invention, both of the digital circuits 504 and 506 are DFF circuits.

## Claims

1. A multi-port static random access memory, SRAM, cell (200) **characterized by**:
a storage circuit (206), configured to store one bit;
a plurality of write port circuits (202_1, 202_2, 202_M'), coupled to a first node (Q) of the storage circuit (206), wherein each of the plurality of write port circuits (202_1, 202_2, 202_M') is coupled to a write word line, WWL, and a write bit line, WBL, and
a plurality of read port circuits (204_1, 204_2, 204_N'), coupled to a second node (QB) of the storage circuit (206), wherein each of the plurality of read port circuits (204_1, 204_2, 204_N') is coupled to a read word line, RWL, and a read bit line, RBL,
wherein the WWL (WWL_1, WWL_2, WWL_M') or the RWL (RWL_1, RWL_2, RWL_N') is asserted more than once during a clock cycle of a clock.

2. The multi-port SRAM cell (200) of claim 1, **characterized in that** the WWL (WWL_1, WWL_2, WWL_M') is asserted twice during the clock cycle.

3. The multi-port SRAM cell (200) of claim 1, **characterized in that** the RWL (RWL_1, RWL_2, RWL_N') is asserted twice during the clock cycle.

4. The multi-port SRAM cell (200) of claim 1, **characterized in that** each of the plurality of write port circuits (202_1, 202_2, 202_M') comprises:
an inverter circuit (212), having an input node and an output node; and
a transmission gate (214), comprising:
a first metal-oxide-semiconductor, MOS, transistor (216), having a control terminal, a first connection terminal, and a second connection terminal; and
a second MOS transistor (218), having a control terminal, a first connection terminal, and a second connection terminal;
wherein the input node of the inverter circuit (212) is coupled to the WWL (WWL_1) and the control terminal of the first MOS transistor (216), the output node of the inverter circuit (212) is coupled to the control terminal of the second MOS transistor (218), the first connection terminal of the first MOS transistor (216) and the first connection terminal of the second MOS transistor (218) are coupled to the WBL (WBL_1), and the second connection terminal of the first MOS transistor (216) and the second connection terminal of the second MOS transistor (218) are coupled to the first node (Q) of the storage circuit (206).

5. The multi-port SRAM cell (200) of claim 1, **characterized in that** the storage circuit (206) is a feedback latch circuit with a feedback loop (210), the plurality of write port circuits (202_1, 202_2, 202_M') are coupled to a plurality of WWLs (WWL_1, WWL_2, WWL_M'), respectively, and the multi-port SRAM cell (200) further comprises:
a logic circuit (208), having a plurality of input nodes coupled to the plurality of WWLs (WWL_1, WWL_2, WWL_M'), respectively, wherein the logic circuit (208) is configured to generate at least one control signal (WWLCUT, WWLBCUT) which determines whether to cut off the feedback loop (210).

6. A static random access memory, SRAM, (100) **characterized by**:
a memory array (102), comprising:
a plurality of SRAM cells (106), each being implemented by the multi-port SRAM cell (200) of claim 1; and
a peripheral circuit (104), configured to control access of the plurality of SRAM cells (106) in the memory array (102).

7. The SRAM (100) of claim 6, **characterized in that** the WWL (WWL_1, WWL_2, WWL_M') is asserted twice during the clock cycle.

8. The SRAM (100) of claim 7, **characterized in that** the peripheral circuit (104) comprises:
a plurality of data-in, DI, circuits (402_1, 402_M'), coupled to the plurality of write port circuits, respectively, wherein each of the plurality of DI circuits (402_1, 402_M') includes:
a first digital circuit (404), configured to store a first bit to be provided to a write port circuit;
a second digital circuit (406), configured to store a second bit to be provided to the write port circuit; and
a multiplexer circuit (408), having a first input node, a second input node, and an output node, wherein the first input node is coupled to the first digital circuit (404), the second input node is coupled to the second digital circuit (406), and the output node is configured to output the first bit during a first phase of the clock cycle and output the second bit during a second phase of the clock cycle.

9. The SRAM (100) of claim 8, **characterized in that** the first digital circuit (404) and the second digital circuit (406) are both triggered by a rising edge of the clock; or
the first digital circuit (404) is triggered by a rising edge of the clock, and the second digital circuit (406) is triggered by a falling edge of the clock.

10. The SRAM (100) of claim 8, **characterized in that** the first digital circuit (404) is a latch circuit, and the second digital circuit (406) is a D-type flip-flop circuit; or
both of the first digital circuit (404) and the second digital circuit (406) are latch circuits.

11. The SRAM (100) of claim 6, **characterized in that** the RWL (RWL_1, RWL_2, RWL_N') is asserted twice during the clock cycle.

12. The SRAM (100) of claim 11, **characterized in that** the peripheral circuit (104) comprises:
a plurality of data-out, DO, circuits (502_1, 502_N'), coupled to the plurality of read port circuits (204_1, 204_2, 204_N'), respectively, wherein each of the plurality of DO circuits (502_1, 502_N') includes:
a first digital circuit (504), configured to store one bit output from a read port circuit during a first phase of the clock cycle; and
a second digital circuit (506), configured to store one bit output from the read port circuit during a second phase of the clock cycle.

13. The SRAM (100) of claim 12, **characterized in that** both of the first digital circuit (504) and the second digital circuit (506) are latch circuits; or
the first digital circuit (504) is a latch circuit, and the second digital circuit (506) is a D-type flip-flop circuit; or
both of the first digital circuit (504) and the second digital circuit (506) are D-type flip-flop circuits.
